# EUROPÄISCHE PATENTANMELDUNG

(11) **EP 1 257 056 A1**
(43) Veröffentlichungstag der Anmeldung: **13.11.2002**
(21) Anmeldenummer: 01810465.3
(22) Anmeldetag: 11.05.2001
(51) Int. Cl.: H03K 17/082

(54) **Verfahren zur Abschaltung eines Bipolartransistors mit isoliert angeordneter Gateelektrode und Vorrichtung zur Durchführung des Verfahrens**

(71) Anmelder: ABB Schweiz AG, 5400 Baden (CH)
(72) Erfinder: Hochstuhl, Gerhard, 79761 Waldshut-Tiengen (DE); Volken, Andreas, 5200 Brugg (CH)
(74) Vertreter: ABB Patent Attorneys

(57) **Zusammenfassung**

Es wird Verfahren zur Abschaltung eines Bipolartransistors mit isoliert angeordneter Gateelektrode (IGBT) (1) angegeben, welche mittels einer die Gate-Kathodenspannung (U_{GK}) zwischen Gateelektrode (G) und Kathode (K) anlegenden Gateelektrodentreiberstufe (2) angesteuert wird, wobei die Anoden-Kathodenspannung des IGBT (1) auf Entsättigung überwacht wird und bei Entsättigung ein Rückmeldesignal (S_{R}) ausgegeben und der Gateelektrodentreiberstufe (2) zugeführt wird. Darüber hinaus wird die Gate-Kathodenspannung (U_{GK}) bei Entsättigung nach Massgabe einer differenzierbaren Funktion bis auf einen Wert in der Grössenordnung des Schwellwertes (U_{S}) der Gate-Kathodenspannung (U_{GK}) reduziert. Ferner wird eine Vorrichtung zur Durchführung des Verfahrens offenbart, welche eine Abschalteinrichtung (4) zur Reduktion der Gate-Kathodenspannung (U_{GK}) umfasst.

## Beschreibung

### Technisches Gebiet

Die Erfindung bezieht sich auf das Gebiet der Leistungselektronik. Sie geht aus von einem Verfahren zur Abschaltung eines Bipolartransistors mit isoliert angeordneter Gateelektrode (IGBT) und einer Vorrichtung zur Durchführung des Verfahrens gemäss dem Oberbegriff der unabhängigen Ansprüche.

### Stand der Technik

Feldgesteuerte Halbleiterschalter, insbesondere Bipolartransistoren mit isoliert angeordneter Gateelektrode (IGBT), werden derzeit vermehrt in leistungselektronischen Anwendungen wie in der Stromrichtertechnik und insbesondere in Stromrichtern für elektrische Antriebe oder Netzkopplungen eingesetzt. Diese werden über ihre Gateelektrode mit Hilfe einer Gateelektrodentreiberstufe durch Anlegen einer entsprechenden Gate-Kathodenspannung angesteuert.

Bei Fehlerfällen in Stromrichteranwendungen kann im Stromrichter in den IGBTs ein Kurzschluss im Hauptstrompfad des IGBTs, d.h. zwischen der Anode und Kathode des IGBTs auftreten. Im Kurzschlussfall steigt dabei der Strom im Hauptstrompfad sehr schnell auf eine hohe Stromamplitude an, so dass das Stromintegral über der Zeit unzulässig hohe Werte annimmt. Während dieses auftretenden Überstromes wird der IGBT in die Entsättigung getrieben, wobei die Anoden-Kathodenspannung am IGBT schnell ansteigt, insbesondere auf den Wert der zu schaltenden Spannung. Dadurch wird ein äusserst kritischer Zustand des IGBTs erreicht: Der IGBT führt zum einen im Hauptstrompfad über die Anode und Kathode einen hohen Strom (Überstrom). Zum anderen liegt gleichzeitig eine hohe Anoden-Kathodenspannung zwischen Anode und Kathode des IGBTs an. Daraus resultiert eine extrem hohe momentane Verlustleistung, die den IGBT zerstören kann.

Eine geeignete Vorrichtung zum Abschalten eines IGBTs ist in der DE 199 18 966 A1 offenbart. Darin wird die Anoden-Kathodenspannung des IGBTs auf Entsättigung überwacht und bei Entsättigung ein Rückmeldesignal ausgegeben, welches der Gateelektrodentreiberstufe zugeführt wird. Auf das Rückmeldesignal hin wird die Gate-Kathodenspannung stufenweise, insbesondere in zwei Stufen reduziert und der IGBT somit abgeschaltet. Diese stufenweise Reduktion der Gate-Kathodenspannung bewirkt eine schnelle, ebenfalls stufenweise verlaufende Reduktion des Überstromes im Hauptstrompfad. Trotz minimaler parasitärer Induktivitäten, insbesondere im Hauptstrompfad an der Anode des IGBTs, werden durch solche schnelle Stromänderungen erhebliche Überspannungen induziert. Diese Überspannungen können die maximal zulässige Sperrspannung des IGBTs überschreiten und den IGBT zerstören.

### Darstellung der Erfindung

Aufgabe der Erfindung ist es deshalb, ein Verfahren zum Abschalten eines Bipolartransistors mit isoliert angeordneter Gateelektrode (IGBT) anzugeben, bei dem Schäden an dem betreffenden IGBT und weiteren Bauelementen vermieden werden können. Ferner ist eine Vorrichtung anzugeben, mit der das Verfahren in besonders einfacher Weise durchgeführt wird. Diese Aufgabe wird durch die Merkmale des Anspruchs 1 und 8 gelöst. In den Unteransprüchen sind vorteilhafte Weiterbildungen der Erfindung angegeben.

Beim erfindungsgemässen Verfahren zur Abschaltung eines Bipolartransistors mit isoliert angeordneter Gateelektrode (IGBT), der mittels einer die Gate-Kathodenspannung zwischen Gateelektrode und Kathode anlegenden Gateelektrodentreiberstufe angesteuert wird, wird die Anoden-Kathodenspannung des IGBTs auf Entsättigung überwacht. Tritt eine Entsättigung auf, so wird ein Rückmeldesignal ausgegeben und der Gateelektrodentreiberstufe zugeführt. Erfindungsgemäss wird die Gate-Kathodenspannung bei Entsättigung nach Massgabe einer differenzierbaren Funktion bis auf einen Wert in der Grössenordnung des Schwellwertes der Gate-Kathodenspannung reduziert. Diese Reduktion bewirkt, dass keine schnellen Stromänderungen, insbesondere sprungartige Stromänderungen im Hauptstrompfad auftreten können, so dass ein Auftreten von induzierten Überspannungen infolge zu schneller Stromänderungen vorteilhaft auf ein Minimum reduziert werden kann. Schäden am IGBT und an weiteren Bauelementen können somit vermieden werden. Weiterhin wird der IGBT durch die vorstehend genannte Reduktion der Gate-Kathodenspannung thermisch weniger stark belastet, wodurch sich seine Lebensdauer erhöht und damit eine erhöhte Verfügbarkeit des IGBTs erreicht werden kann und zudem Kosten eingespart werden können.

Die erfindungsgemässe Vorrichtung zur Durchführung des Verfahrens zur Abschaltung eines IGBTs umfasst eine die Gate-Kathodenspannung an die Gateelektrode und Kathode des IGBTs anlegende Gateelektrodentreiberstufe. Ferner weist die Vorrichtung eine mit der Anode und der Kathode des IGBTs verbundene Entsättigungsüberwachungseinrichtung zur Ausgabe des Rückmeldesignals bei Entsättigung des IGBTs auf, die mit der Gateelektrodentreiberstufe verbunden ist. Desweiteren ist eine Abschalteinrichtung zur Reduktion der Gate-Kathodenspannung bis auf einen Wert in der Grössenordnung des Schwellwertes der Gate-Kathodenspannung nach Massgabe einer differenzierbaren Funktion vorgesehen, die mit der Gateelektrode und der Kathode des IGBTs verbunden ist. Die erfindungsgemässe Vorrichtung zur Durchführung ist somit sehr einfach und kostengünstig realisierbar, da der Schaltungsaufwand äusserst gering gehalten werden kann und zudem nur eine geringe Anzahl an Bauelementen für den Aufbau benötigt wird.

In einer bevorzugten Ausführungsform der erfindungsgemässen Vorrichtung weist die Abschalteinrichtung einen Schalter mit einer zeitlich veränderbaren Widerstandscharakteristik auf. Dadurch kann die differenzierbare Funktion, nach welcher die Reduktion der Gate-Kathodenspannung erfolgt, besonders einfach erzeugt werden, so dass vorteilhaft eine weitere Reduktion der Kosten erreicht werden kann.

Diese und weitere Aufgaben, Vorteile und Merkmale der vorliegenden Erfindung werden aus der nachfolgenden detaillierten Beschreibung eines bevorzugten Ausführungsbeispiels der Erfindung in Verbindung mit der Zeichnung offensichtlich.

### Kurze Beschreibung der Zeichnungen

Es zeigen:
- Fig. 1: eine Ausführungsform einer erfindungsgemässen Vorrichtung zur Durchführung eines Verfahrens zur Abschaltung eines Bipolartransistors mit isoliert angeordneter Gateelektrode (IGBT),
- Fig. 2: eine Ausführungsform einer erfindungsgemässen Abschalteinrichtung und
- Fig. 3: ein zeitlicher Verlauf der Gate-Kathodenspannung des IGBTs für einen Abschaltvorgang des IGBTs.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebene Ausführungsform steht beispielhaft für den Erfindungsgegenstand und hat keine beschränkende Wirkung.

### Wege zur Ausführung der Erfindung

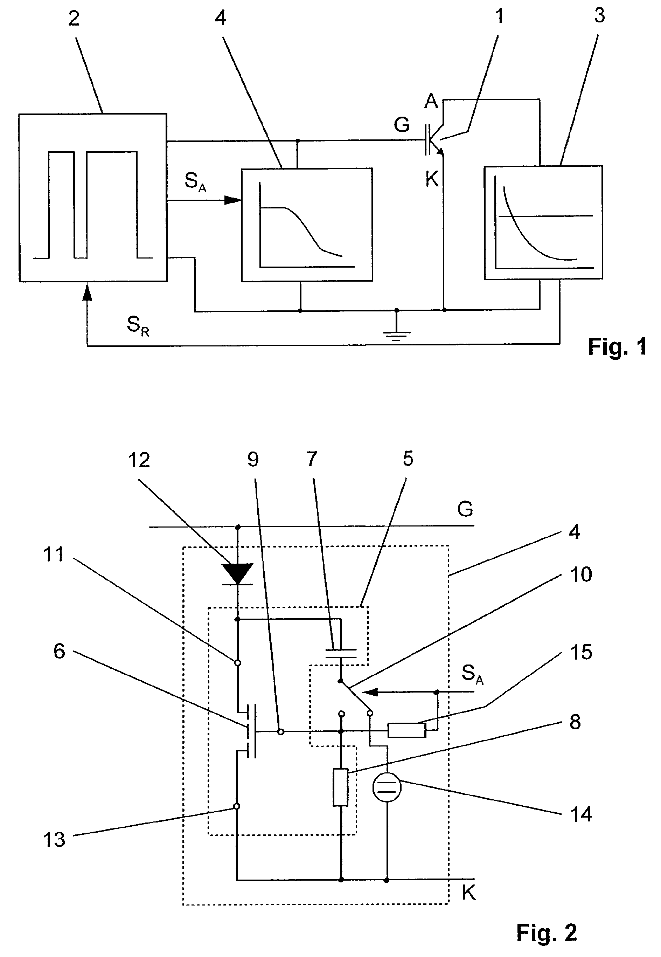

In Fig. 1 ist eine Ausführungsform einer erfindungsgemässen Vorrichtung zur Durchführung eines Verfahrens zur Abschaltung eines Bipolartransistors mit isoliert angeordneter Gateelektrode (IGBT) 1 dargestellt. Die Vorrichtung weist eine Gateelektrodentreiberstufe 2 auf, die gemäss Fig. 1 mit der Gateelektrode G des IGBTs 1 und der Kathode K des IGBTs 1 verbunden ist, wobei die Gateelektrodentreiberstufe 2 den IGBT 1 durch Anlegen einer Gate-Kathodenspannung U_{GK}, insbesondere durch Anlegen eines positiven Spannungspotentials für die Gate-Kathodenspannung U_{GK} für das Einschalten des IGBTs 1, ansteuert.

Beim erfindungsgemässen Verfahren wird die zwischen der Anode A des IGBTs 1 und der Kathode K anliegende Anoden-Kathodenspannung auf Entsättigung hin überwacht. Tritt diese Entsättigung auf, d.h. steigt die Anoden-Kathodenspannung bei eingeschaltetem IGBT 1 auf einen unzulässigen Wert an, wird ein Rückmeldesignal S_{R} ausgegeben und der Gateelektrodentreiberstufe 2 zugeführt. Erfindungsgemäss wird dann die Gate-Kathodenspannung U_{GK} bei der vorstehend beschriebenen Entsättigung des IGBTs 1 nach Massgabe einer differenzierbaren Funktion bis auf einen Wert in der Grössenordnung des Schwellwertes U_{S} der Gate-Kathodenspannung U_{GK} reduziert. Die Reduktion nach Massgabe der differenzierbaren Funktion bewirkt vorteilhaft, dass keine schnellen Stromänderungen im Hauptsrompfad zwischen Anode A und Kathode K, insbesondere sprungartige Stromänderungen auftreten können. Ein Auftreten von Überspannungen, hervorgerufen durch Induktion an parasitären Induktivitäten, insbesondere im Hauptsrompfad an der Anode A, kann somit in erwünschtem Masse reduziert werden. Ferner können Schäden am IGBT 1 oder an weiteren in Fig. 1 der Übersichtlichkeit halber nicht dargestellten Bauelementen durch die Reduktion der Gate-Kathodenspannung U_{GK} erfolgreich vermieden werden. Vorzugsweise wird auf das Rückmeldesignal S_{R} hin ein Abschaltsignal S_{A} erzeugt und durch Ausgabe des Abschaltsignals S_{A} mit der vorstehend erläuterten Reduktion gestartet.

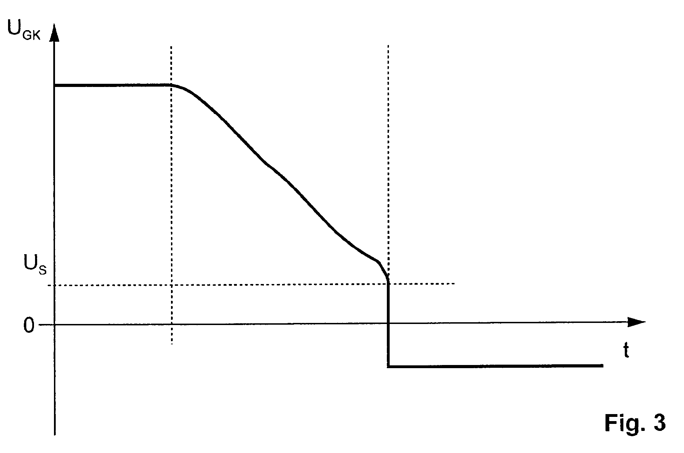

In Fig. 3 ist ein zeitlicher Verlauf der Gate-Kathodenspannung U_{GK} für einen Abschaltvorgang des IGBTs 1 gezeigt, wobei die Gate-Kathodenspannung U_{GK} bei eingeschaltetem IGBT 1 auf einem positiven Spannungspotential liegt, bevor mit der Reduktion der Gate-Kathodenspannung U_{GK} gestartet wird. Gemäss Fig. 3 verläuft die Reduktion nach einer differenzierbaren Funktion. Für die Reduktion der Gate-Kathodenspannung U_{GK} hat sich als vorteilhaft erwiesen, dass die differenzierbare Funktion im wesentlichen rampenförmig verläuft. Gemäss Fig. 3 weist eine solche Funktion keine undifferenzierbaren Stellen, wie beispielsweise Knicke, auf, so dass keine schnellen Stromänderungen im Hauptstrompfad bewirkt werden und somit eine weitere Reduzierung des Auftretens von Überspannungen erreicht werden kann. Vorzugsweise erfolgt die Reduktion der Gate-Kathodenspannung U_{GK} zeitlich im Bereich zwischen 2µs und 6µs. Durch diesen Bereich wird vorteilhaft erreicht, dass die momentane Verlustleistung des IGBT nicht auf unzulässig hohe Werte ansteigt und gleichzeitig keine unzulässig hohen Überspannungen erzeugt werden.

Erfindungsgemäss wird die Gate-Kathodenspannung U_{GK}, wie bereits vorstehend erwähnt, bis auf einen Wert in der Grössenordnung des Schwellwertes U_{S} der Gate-Kathodenspannung U_{GK} reduziert. Diese Reduktion bis auf einen Wert in der Grössenordnung des Schwellwertes U_{S} der Gate-Kathodenspannung U_{GK} bewirkt, dass der Strom im Hauptstrompfad im Falle einer Entsättigung des IGBTs 1 soweit reduziert wird, dass der IGBT 1 abgeschaltet werden kann, ohne dass sich der Strom derart ändert, dass unzulässig hohe Überspannungen infolge von Induktion in parasitären Induktivitäten im Hauptstrompfad erzeugt werden. Nach dieser Reduktion wird die Gate-Kathodenspannung U_{GK} erfindungsgemäss auf einen Wert unterhalb des Schwellwertes U_{S} der Gate-Kathodenspannung U_{GK} abgesenkt, wobei dieses Absenkung vorteilhaft mittels der Gateelektrodentreiberstufe 2 erfolgt. Die Gateelektrodentreiberstufe 2 legt dazu ein negatives Spannungspotential zwischen die Gateelektrode G und der Kathode K an, so dass die Gate-Kathodenspannung U_{GK} auf das negative Spannungspotential gezogen wird und der IGBT 1 in gewünschter Weise abgeschaltet werden kann.

Die erfindungsgemäss Vorrichtung zur Durchführung des Verfahrens weist gemäss der in Fig. 1 dargestellten Ausführungsform neben der bereits genannten Gateelektrodentreiberstufe 2 eine mit der Anode A des IGBTs 1 und der Kathode K verbundene Entsättigungsüberwachungseinrichtung 3 auf, die der Ausgabe des Rückmeldesignals S_{R} bei Entsättigung des IGBTs 1 dient. Diese Entsättigungsüberwachungseinrichtung 3 ist zur Zuführung des Rückmeldesignals S_{R} an die Gateelektrodentreiberstufe 2 mit dieser verbunden.

Erfindungsgemäss umfasst die Vorrichtung gemäss Fig.1 eine zur Reduktion der Gate-Kathodenspannung U_{GK} vorgesehene Abschalteinrichtung 4, die die Gate-Kathodenspannung U_{GK} bis auf einen Wert in der Grössenordnung des Schwellwertes U_{S} der Gate-Kathodenspannung U_{GK} nach Massgabe einer differenzierbaren Funktion reduziert, wobei die Abschalteinrichtung 4 mit der Gateelektrode G und der Kathode K verbunden ist. Dadurch wird ein besonders einfach zu realisierender Aufbau erreicht, der zudem kostengünstig ist, da der Schaltungsaufwand sehr gering gehalten werden kann und nur wenige Bauteile für einen Aufbau benötigt werden.

Die Gateelektrodentreiberstufe 2 dient der Erzeugung des Abschaltsignals S_{A} auf das Rückmeldesignal S_{R} hin, wobei durch die Ausgabe des Abschaltsignals S_{A} an die Abschalteinrichtung 4 mit der Reduktion der Gate-Kathodenspannung U_{GK} in beschriebener Weise gestartet wird. Zu diesem Zweck ist die Gateelektrodentreiberstufe 2 mit der Abschalteinrichtung 4 verbunden.

Im folgenden wird eine Ausführungsform einer erfindungsgemässen Abschalteinrichtung 4, die in Fig. 2 dargestellt ist, näher erläutert. Gemäss Fig. 2 weist die Abschalteinrichtung 4 einen Schalter 5 mit einer zeitlich veränderbaren Widerstandscharakteristik auf. Dadurch kann die differenzierbare Funktion, nach welcher die Reduktion der Gate-Kathodenspannung U_{GK} erfolgt, besonders einfach erzeugt werden. Der Schalter 5 umfasst gemäss Fig. 2 einen Metall-Oxid-Feldeffekttransistor (MOSFET) 6, einen Kondensator 7 sowie einen ersten Widerstand 8. Am Steueranschluss 9 des MOSFETs 6 ist ein Umschalter 10 angeschlossen, der durch das Abschaltsignal S_{A} der Gateelektrodentreiberstufe 2 steuerbar ist. Mittels des Umschalters 10 ist der Kondensator 7 mit dem Steueranschluss 9 verbindbar. Weiterhin ist eine Spannungsquelle 14, die vorzugsweise als Gleichspannungsquelle ausgebildet ist, durch den Umschalter 10 mit dem Kondensator 7 verbindbar. Darüber hinaus ist der Kondensator 7 gemäss Fig. 2 mit einem ersten Hauptanschluss 11 des MOSFETs 6 verbunden, wobei der erste Hauptanschluss 11 zudem über eine Diode 12 mit der Gateelektrode G des IGBTs 1 verbunden ist. Der erste Widerstand 8 des Schalters 5 ist gemäss Fig. 2 mit dem Steueranschluss 9 und einem zweiten Hauptanschluss 13 des MOSFETs 6 verbunden, wobei der zweite Hauptanschluss 13 mit der Kathode K des IGBTs 1 verbunden ist. Weiterhin ist ein zweiter Widerstand 15 vorgesehen, der mit dem Steueranschluss 9 verbunden ist. Gemäss Fig. 2 ist der MOSFET 6 durch das Abschaltsignal S_{A} an seinem Steueranschluss 9 über den zweiten Widerstand 15 steuerbar.

Im Normalbetrieb des eingeschalteten IGBTs 1 ist der Umschalter 10 derart umgelegt, dass der Kondensator 7 mit der Spannungsquelle 14 verbunden ist. Der Kondensator 7 ist damit auf den Spannungswert aufgeladen, der der Gate-Kathodenspannung U_{GK} abzüglich des Wertes der Spannungsquelle 14 entspricht. In diesem Zustand sperrt der MOSFET 6. Tritt nun eine Entsättigung des IGBTs 1 auf, so wird der Umschalter 10 durch das bei Entsättigung durch die Gateelektrodentreiberstufe 2 ausgegebene Abschaltsignal S_{A} derart angesteuert, dass der Umschalter 10 den Kondensator 7 mit dem Steueranschluss 9 des MOSFETs 6 verbindet. Gleichzeitig wird der MOSFET 6 durch das Abschaltsignal S_{A} an seinem Steueranschluss 9 über den zweiten Widerstand 15 angesteuert. Durch den bereits vorgeladenen Kondensator 7 kann der MOSFET 6 sehr schnell an den Anfangswert des leitenden Zustands des MOSFETs 6 geführt werden, ohne dass kostbare Zeit vergeht, bis dieser Punkt erreicht ist. Zudem können damit vorteilhaft undifferenzierbare Stellen, wie Knicke oder Spitzen beim Start der Reduktion der Gate-Kathodenspannung U_{GK} vermieden werden. Ferner lädt sich der Kondensator 7 derart um, dass sich die Spannung am Steueranschluss 9 erhöht und der Strom zwischen erstem Hauptanschluss 11 und zweitem Hauptanschluss 13 fortlaufend ansteigt und der MOSFET 6 mehr und mehr leitet. Mit diesem Stromanstieg geht die bereits beschriebene Reduktion der Gate-Kathodenspannung U_{GK} einher, wie dies im zeitlichen Verlauf der Gate-Kathodenspannung U_{GK} für einen Abschaltvorgang des IGBTs 1 gemäss Fig. 3 gezeigt ist. Der Schalter 5 weist somit eine zeitlich veränderbare Widerstandscharakteristik auf, die einem zeitlich kleiner werdenden Widerstandsverhalten entspricht. Mit diesem zeitlichen Verhalten der Widerstandscharakteristik ist die differenzierbare Funktion zur Reduktion der Gate-Kathodenspannung U_{GK} besonders einfach realisierbar. Der zeitliche Verlauf dieser Reduktion kann durch Wahl des Wertes des ersten Widerstands 8, des zweiten Widerstands 15 und des Wertes des Kondensators 7 präzise und mit wenig Aufwand eingestellt werden. Desweiteren ist mit dieser Wahl auch eine sehr genaue Einstellung des Wertes möglich, auf den die Gate-Kathodenspannung U_{GK} reduziert werden soll, wobei dieser Wert vorteilhaft in der Grössenordnung des Schwellwertes U_{S} der Gate-Kathodenspannung U_{GK} liegt. Die weitere Absenkung der Gate-Kathodenspannung U_{GK} erfolgt durch die Gateelektrodentreiberstufe 2 in bereits erläuterter Weise.

Insgesamt zeichnet sich die erfindungsgemässe Vorrichtung durch einen sehr einfachen und kostengünstigen Aufbau aus, da der Schaltungsaufwand äusserst gering ist und zudem nur eine geringe Anzahl an Bauelementen für den Aufbau benötigt wird.

### Bezugszeichenliste

- 1: Bipolartransistor mit isoliert angeordneter Gateelektrode (IGBT)
- 2: Gateelektrodentreiberstufe
- 3: Entsättigungsüberwachungseinrichtung
- 4: Abschalteinrichtung
- 5: Schalter
- 6: Metall-Oxid-Feldeffekttransistor (MOSFET)
- 7: Kondensator
- 8: erster Widerstand
- 9: Steueranschluss
- 10: Umschalter
- 11: erster Hauptanschluss
- 12: Diode
- 13: Zweiter Hauptanschluss
- 14: Spannungsquelle
- 15: zweiter Widerstand

## Patentansprüche

1. Verfahren zur Abschaltung eines Bipolartransistors mit isoliert angeordneter Gateelektrode (IGBT) (1), welcher mittels einer die Gate-Kathodenspannung (U_{GK}) zwischen Gateelektrode (G) und Kathode (K) anlegenden Gateelektrodentreiberstufe (2) angesteuert wird, wobei die Anoden-Kathodenspannung des IGBT (1) auf Entsättigung überwacht wird und bei Entsättigung ein Rückmeldesignal (S_{R}) ausgegeben und der Gateelektrodentreiberstufe (2) zugeführt wird, **dadurch gekennzeichnet,**
**dass** die Gate-Kathodenspannung (U_{GK}) bei Entsättigung nach Massgabe einer differenzierbaren Funktion bis auf einen Wert in der Grössenordnung des Schwellwertes (U_{S}) der Gate-Kathodenspannung (U_{GK}) reduziert wird.

2. Verfahren nach Anspruch 1, **dadurch gekennzeichnet, dass** auf das Rückmeldesignal (S_{R}) hin ein Abschaltsignal (S_{A}) erzeugt wird und durch Ausgabe des Abschaltsignals (S_{A}) mit der Reduktion der Gate-Kathodenspannung (U_{GK}) gestartet wird.

3. Verfahren nach Anspruch 1 oder 2, **dadurch gekennzeichnet, dass** die Funktion im wesentlichen rampenförmig verläuft.

4. Verfahren nach einem der vorhergehenden Ansprüche, **dadurch gekennzeichnet, dass** die Reduktion der Gate-Kathodenspannung (U_{GK}) zeitlich im Bereich zwischen 2µs und 6µs erfolgt.

5. Verfahren nach einem der vorhergehenden Ansprüche, **dadurch gekennzeichnet, dass** die Gate-Kathodenspannung (U_{GK}) nach der Reduktion auf einen Wert unterhalb des Schwellwertes (U_{S}) abgesenkt wird.

6. Verfahren nach Anspruch 5, **dadurch gekennzeichnet, dass** die Absenkung der Gate-Kathodenspannung (U_{GK}) mittels der Gateelektrodentreiberstufe (2) erfolgt.

7. Verfahren nach Anspruch 6, **dadurch gekennzeichnet, dass** die Gateelektrodentreiberstufe (2) ein negatives Spannungspotential zwischen der Gateelektrode (G) und der Kathode (K) anlegt.

8. Vorrichtung zur Durchführung eines Verfahrens zur Abschaltung eines Bipolartransistors mit isoliert angeordneter Gateelektrode (IGBT), welche eine die Gate-Kathodenspannung (U_{GK}) an die Gateelektrode (G) und Kathode (K) des IGBTs (1) anlegende Gateelektrodentreiberstufe (2) umfasst und eine mit der Anode (A) und der Kathode (K) des IGBT (1) verbundene Entsättigungsüberwachungseinrichtung (3) zur Ausgabe eines Rückmeldesignals (S_{R}) bei Entsättigung des IGBTs (1) aufweist, die mit der Gateelektrodentreiberstufe (2) verbunden ist, **dadurch gekennzeichnet,**
**dass** eine zur Reduktion der Gate-Kathodenspannung (U_{GK}) bis auf einen Wert in der Grössenordnung des Schwellwertes (U_{S}) der Gate-Kathodenspannung (U_{GK}) nach Massgabe einer differenzierbaren Funktion vorgesehene Abschalteinrichtung (4) mit der Gateelektrode (G) und der Kathode (K) verbunden ist.

9. Vorrichtung nach Anspruch 8, **dadurch gekennzeichnet, dass** die Gateelektrodentreiberstufe (2) zur Ausgabe eines auf das Rückmeldesignal (S_{R}) hin erzeugtes Abschaltsignals (S_{A}) an die Abschalteinrichtung (4) mit der Abschalteinrichtung (4) verbunden ist.

10. Vorrichtung nach Anspruch 9, **dadurch gekennzeichnet, dass** die Abschalteinrichtung (4) einen Schalter (5) mit einer zeitlich veränderbaren Widerstandscharakteristik aufweist.

11. Vorrichtung nach Anspruch 10, **dadurch gekennzeichnet, dass** der Schalter (5) einen Metall-Oxid-Feldeffekttransistor (MOSFET) (6), einen Kondensator (7) und einen ersten Widerstand (8) aufweist.

12. Vorrichtung nach Anspruch 11, **dadurch gekennzeichnet, dass** am Steueranschluss (9) des MOSFET (6) ein durch das Abschaltsignal (S_{A}) steuerbarer Umschalter (10) angeschlossen ist, wobei der Kondensator (7) durch den Umschalter (10) mit dem Steueranschluss (9) verbindbar ist.

13. Vorrichtung nach Anspruch 12, **dadurch gekennzeichnet**, ein zweiter Widerstand (15) mit dem Steueranschluss (9) verbunden ist, wobei der MOSFET (6) durch das Abschaltsignal (S_{A}) an seinem Steueranschluss (9) über den zweiten Widerstand (15) steuerbar ist.

14. Vorrichtung nach einem der Ansprüche 11 bis 13, **dadurch gekennzeichnet, dass** der Kondensator (7) mit einem ersten Hauptanschluss (11) des MOSFETs (6) verbunden ist, wobei der erste Hauptanschluss (11) über eine Diode (12) mit der Gateelektrode (G) des IGBTs (1) verbunden ist.

15. Vorrichtung nach einem der Ansprüche 12 bis 14, **dadurch gekennzeichnet, dass** der erste Widerstand (8) mit dem Steueranschluss (9) und einem zweiten Hauptanschluss (13) des MOSFETs (6) verbunden ist, wobei der zweite Hauptanschluss (13) mit der Kathode (K) des IGBTs (1) verbunden ist.

16. Vorrichtung nach Anspruch 12, **dadurch gekennzeichnet, dass** eine Spannungsquelle (14) durch den Umschalter (10) mit dem Kondensator (7) verbindbar ist.
